Europäisches Patentamt

European Patent Office

Office européen des brevets

(19)

(11) Veröffentlichungsnummer : **0 044 909**
**B1**

(12)             EUROPÄISCHE PATENTSCHRIFT

(45) Veröffentlichungstag der Patentschrift :
07.12.83

(21) Anmeldenummer : 81102687.1

(22) Anmeldetag : 09.04.81

(51) Int. Cl.³ : **H 03 H   7/48,** H 03 H   7/46,
**H 04 N   5/14**

(54) **Mehrfach-Abzweigeinrichtung für Hochfrequenzsignale.**

(30) Priorität : 29.07.80 DE 3028683

(43) Veröffentlichungstag der Anmeldung :
03.02.82 Patentblatt 82/05

(45) Bekanntmachung des Hinweises auf die Patenterteilung : 07.12.83 Patentblatt 83/49

(84) Benannte Vertragsstaaten :
AT CH FR GB IT LI NL SE

(56) Entgegenhaltungen :
DE-A- 1 276 146
DE-A- 2 425 722
DE-A- 2 606 449
DE-A- 2 703 258

(73) Patentinhaber : Richard Hirschmann Radiotechnisches Werk
Richard-Hirschmann-Strasse 19
D-7300 Esslingen a.N. (DE)

(72) Erfinder : Wendel, Wolfgang, Dipl.-Ing.
Dürrbeundstrasse 8
D-7300 Esslingen (Berkheim) (DE)

(74) Vertreter : Stadler, Heinz, Dipl.-Ing.
Richard Hirschmann Radiotechnisches Werk
Richard-Hirschmann-Strasse 19
D-7300 Esslingen a.N. (DE)

# 0 044 909

## Mehrfach-Abzweigeinrichtung für Hochfrequenzsignale

Die Erfindung betrifft eine Mehrfach-Abzweigeinrichtung für Hochfrequenzsignale im VHF/UHF-Bereich (5-860 MHz), insbesondere zur Verwendung in Gemeinschafts-Antennenanlagen, bestehend aus wenigstens zwei in Kette geschalteten Richtkopplern zum breitbandig richtungsabhängigen Auskoppeln eines Teils der über eine Stammleitung geführten Signalenergie auf jeweils einen Abzweiganschluß, die derart ausgebildet sind, daß sie — in alternierender Reihenfolge zusammengeschaltet — nacheinander die jeweilige Eingangsimpedanz herab- bzw. herauftransformieren. Solche Abzweigeinrichtungen werden beispielsweise in Gemeinschafts- und Kabelfernsehanlagen dazu benutzt, Signale mit bestimmten, gleichen oder unterschiedlichen Dämpfungen aus einer Hauptleitung auf weiterführende Leitungen, Verteileinrichtungen oder auch direkt auf Antennenanschlußdosen auszukoppeln. Dabei soll schon im Teilnehmernetz, erst recht aber bei Verwendung in übergeordneten Ebenen (Linien- bzw. Streckennetz) für den gesamten Betriebsfrequenzbereich gewährleistet sein, daß die Abzweigeinrichtung bei beliebigen Auskoppeldämpfungen allseitig an den Wellenwiderstand der angeschlossenen Leitungen angepaßt und eine möglichst große Koppeldämpfung zwischen allen Ausgängen erzielt ist.

Eine Mehrfach-Abzweigeinrichtung der eingangs genannten Art ist aus der DE-AS 24 25 722 bekannt. Bei ihr sind die genannten Anforderungen zwar angestrebt, aber nur in unzureichendem Maße erfüllt, sodaß sie für viele angegebene Einsatzfälle praktisch unbrauchbar ist.

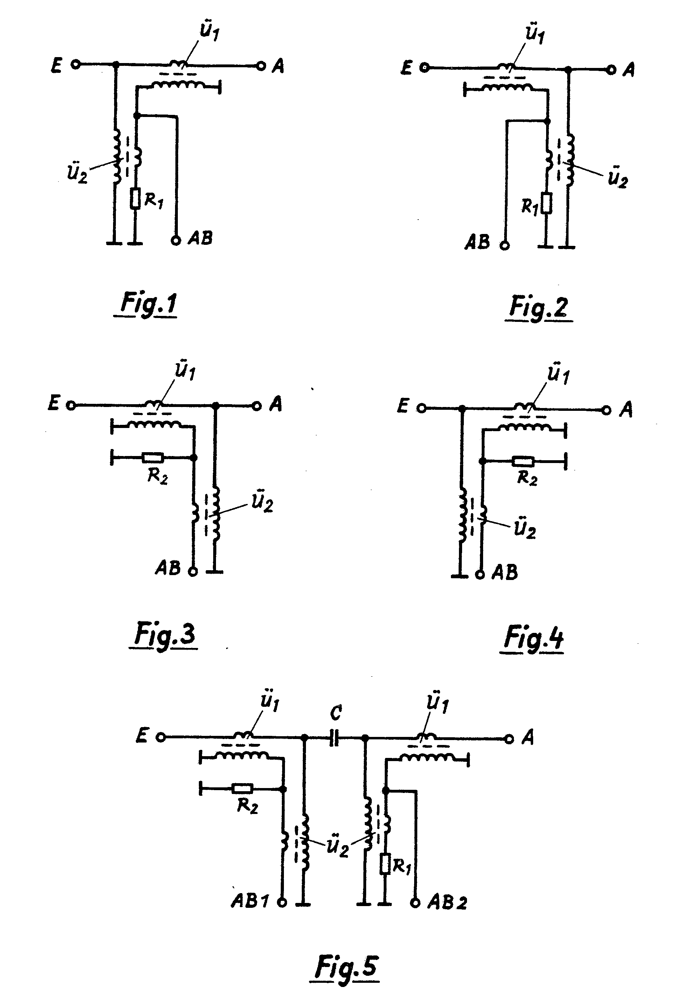

Gegenüber den seither gebräuchlichen und praktisch ausschließlich benutzten Mehrfach-Abzweigeinrichtungen, wie sie beispielsweise aus den DE-OS 23 43 403 und 27 03 258, sowie den DE-AS 24 48 737 und 26 06 449 bekannt sind, bei denen wegen der Serienschaltung gleicher Richtkoppler, die alle den Eingangswiderstand in gleichem Sinne, in den angeführten Beispielen zu niedrigeren Werten hin, transformieren und dadurch eine schon bei geringer Anzahl von Abzweigern untragbar schlechte Anpassung und damit auch Entkopplung aufweisen, ist bei dieser Einrichtung zwar eine Kompensation durch Hintereinanderschalten von aufwärts und abwärts transformierenden Richtkopplern vorgesehen (siehe Spalte 4, Zeilen 4-8 der DE-AS 24 25 722), die jedoch insbesondere bei einer größeren Anzahl von Abzweigern ungenügend ist. Schon bei einem Zweifach-Abzweiger mit 14 dB Auskoppeldämpfung gemäß Fig. 5 der DE-AS 24 25 722 wird die Eingangsimpedanz von 75 Ohm in eine Ausgangsimpedanz von höchstens (frequenzabhängig) etwa 60 Ohm transformiert. Diese Abweichung wird noch erheblich größer bei Abzweigern mit geringerer Auskoppeldämpfung. Die Anpassung am ersten Abzweig mag mit etwa 80 % der Eingangsimpedanz noch für manche Fälle ausreichen (wobei mit der Wahl des Widerstandes R ein Kompromiß zwischen Entkopplung und Anpassung getroffen ist), die des zweiten Abzweigs ist jedoch mit typisch 50 % der Ein — gangsimpedanz ohne Anpassungsübertrager oder den in der Vorveröffentlichung vorgesehenen zusätzlichen Anpaßwiderstand $R_A$ nicht tragbar. Dieser stellt indessen nicht nur einen zusätzlichen Aufwand dar, sondern erhöht zusätzlich die Auskoppeldämpfung, sodaß der eigentliche Richtkoppler für eine kleinere Auskoppeldämpfung zu bemessen ist. Dadurch steigen die Durchgangsdämpfungen, die Kettenschaltung wird unsymmetrisch, die erwünschten entgegengesetzt gleichen Transformationsverhältnisse stimmen noch weniger und die Entkopplung wird schlechter.

In der Praxis ist es meist wünschenswert, alle Teilnehmer einer Gemeinschaftsantennenanlage mit Signalen etwa gleichen Pegels zu versorgen. Dazu muß am Anfang einer Stammleitung die Auskoppeldämpfung höher sein als am Ende. Bei längeren Stammleitungen sind dabei auch verhältnismäßig niedere Auskoppeldämpfungen notwendig, im Extremfall bis zu 3 dB (Verteiler). Abzweiger, deren Auskoppeldämpfung kleiner ist als 10 dB sind seither nicht mit ausreichenden Rückflußdämpfungen realisierbar. Bei dem speziellen Fall des aus der DE-AS 24 25 722 bekannten Mehrfach-Abzweigers werden die genannten Mängel für kleinere Aus — koppeldämpfungen noch schlimmer, weil dabei der Anpassungswiderstand $R_A$ mit den bereits beschriebenen Folgen noch größer bemessen werden müßte. Insgesamt sind also bei dieser bekannten Mehrfach-Abzweigeinrichtung weder größere Kettenschaltungen noch Abzweiger mit Auskoppeldämpfungen unter 10 dB mit ausreichend guten elektrischen Daten erreichbar. Schließlich sind bei dieser Einrichtung noch zusätzlich besondere Maßnahmen zur Erweiterung des UHF-Frequenzbereiches bis 860 MHz (siehe kennzeichnenden Teil des Anspruches 1) notwendig, welche den Bauteile- und Herstellungsaufwand und damit auch die Kosten weiter erhöhen. Der Erfindung liegt die Aufgabe zugrunde, eine Mehrfach-Abzweigeinrichtung nach dem Oberbegriff des Anspruches 1 zu schaffen, die über den gesamten Betriebsfrequenzbereich unabhängig von der Anzahl der hintereinander geschalteten Richtkoppler eine hohe Entkopplung zwischen allen Ausgängen, sowie tatsächlich allseitige Anpassung gewährleistet und auch kleine Auskoppeldämpfungen ermöglicht.

Diese Aufgabe ist erfindungsgemäß dadurch gelöst, daß jeder Richtkoppler zwei voneinander getrennte Übertrager aufweist, wobei die Primärwicklung des ersten (Strom-Übertragers) zwischen dem Eingang und dem Ausgang, diejenige des zweiten (Spannungsübertragers) zwischen Eingang oder Ausgang und Masse liegt und die Sekundärwicklung des Stromübertragers einerseits mit Masse und andererseits mit der Sekundärwicklung des Spannungsübertragers verbunden ist, und daß bei den herabtransformierenden Richtkopplern der Abzweig-Anschluß zwischen den beiden Sekundärwicklungen und das andere Ende der Sekundärwicklung des Spannungsübertragers über einen ohm'schen Widerstand an Masse liegt, während bei den aufwärts transformierenden Richtkopplern der Widerstand zwischen dem Verbindungspunkt der Sekundärwicklungen und Masse eingeschaltet ist und das andere Ende der Sekundärwicklung des Spannungsübertragers den Abzweiganschluß bildet.

Derartige Richtkoppler gibt es in zwei unterschiedlichen Grundausführungen und deren dualen Schaltungen, die in den Fig. 1 und 3 bzw. 2 und 4 dargestellt sind. Die Schaltungen nach Fig. 1 und 2 (Typ A) transformieren die Eingangsimpedanz zu niedrigeren, diejenigen nach Fig. 3 und 4 (Typ B) zu höheren Werten. Damit ist eine Kompensation durch alternierendes Hintereinanderschalten von Richtkopplern des Typs A und B möglich. Optimal ist diese Aufwärts- und Abwärts-Transformation, wenn Richtkoppler gemäß den Fig. 1 und 3 bzw. den Fig. 2 und 4 abwechselnd aufeinander folgen. Für den ersten Fall ergeben sich bei idealer Entkopplung (unendlich große Koppeldämpfung zwischen Abzweig und Ausgang) und Abschluß der jeweils freien Anschlüsse mit dem Wellenwiderstand der angeschlossenen Leitungen folgende Werte :

|  | Schaltung nach Fig. 1 | | Schaltung nach Fig. 3 | |
|---|---|---|---|---|
| $Z_E$ | $\dfrac{2\,n^2 - (1/n^2)}{2\,n^2 + (1/n^2) - 2} \cdot Z_L$ | $(1{,}1\,Z_L)$ | $\dfrac{2\,n^2 + (1/n^2) - 2}{2\,n^2 - (1/n^2)} \cdot Z_L$ | $((1/1{,}1) \cdot Z_L)$ |
| $Z_A$ | $(1 - 1/n^2) \cdot Z_L$ | $(0{,}9\,Z_L)$ | $\dfrac{1}{1 - (1/n^2)} \cdot Z_L$ | $((1/0{,}9) \cdot Z_L)$ |
| $Z_{AB}$ | $Z_L$ | $(Z_L)$ | $Z_L$ | $(Z_L)$ |
| $a_A$ | $20 \log (1/n)$ | $(10\ \text{dB})$ | $20 \log (1/n)$ | $(10\ \text{dB})$ |
| $a_d$ | $20 \log \dfrac{2\,(n^2 - 1)}{2\,n^2 - 1}$ | $(0{,}47\ \text{dB})$ | $20 \log \dfrac{2\,(n^2 - 1)}{2\,n^2 - 1}$ | $(0{,}47\ \text{dB})$ |
| $R$ | $(1 - (1/n^2)) \cdot Z_L$ | $(0{,}9\,Z_L)$ | $\dfrac{1}{1 - (1/n^2)} \cdot Z_L$ | $((1/0{,}9) \cdot Z_L)$ |

Dabei bedeutet n das Windungszahlenverhältnis beider Übertrager der Richtkoppler, $Z_L$ den Wellenwiderstand der angeschlossenen Leitungen, $Z_E$, $Z_A$ und $Z_{AB}$ die Impedanzen an Eingang, Ausgang und Abzweig, $a_A$ die Auskoppeldämpfung und $a_d$ die Stammdurchgangsdämpfung.

Aus den rechnerisch ermittelten Formeln ist ohne weiteres erkennbar, daß bei einer Hintereinanderschaltung der beiden Richtkoppler, bei der also der Eingang des zweiten nicht mit $Z_L$, sondern mit der Ausgangsimpedanz $Z_A$ des ersten Richtkopplers abgeschlossen ist, alle Impedanzen frequenz unabhängig gleich dem Wellenwiderstand $Z_L$ sind, sodaß also bei idealer Entkopplung sowohl der Abzweige vom Ausgang, als auch der Abzweige untereinander allseitige Anpassung erreicht ist, wenn der Widerstand $R_1$ bzw. $R_2$ den angegebenen Entkopplungsbedingungen entsprechend bemessen ist. Als Beispiel sind die für einen Zweifachabzweiger mit einer Auskoppeldämpfung von 10 dB ($n^2 = 10$) berechneten Werte in der obigen Tabelle in Klammern aufgeführt.

Diese rechnerischen Werte werden natürlich in der Praxis nicht ganz erreicht. Die Abweichungen von den theoretischen Idealwerten sind hauptsächlich darauf zurückzuführen, daß

1. die erhältlichen Widerstände in der Regel nicht genau den berechneten Werten entsprechen und im übrigen wie alle anderen Bauteile Toleranzen aufweisen,

2. die Windungszahlverhältnisse bei vertretbaren Windungszahlen oftmals nicht exakt realisierbar sind bzw. zum Erreichen bestimmter geforderter Werte der Auskoppeldämpfung für die beiden Übertrager unterschiedlich gewählt sind, wobei für den Widerstand R ein Wert zu wählen ist, der einen Kompromiß zwischen guter Anpassung des Abzweigs und hoher Entkopplung ergibt,

3. im Falle festgelegter konstanter aus der Stammleitung auszukoppelnder Signalenergie von der Auskoppeldämpfung des n-ten Richtkopplers der Wert $(n - 1)\,a_d$ abzuziehen ist.

Diese Abweichungen sind jedoch insgesamt verhältnismäßig gering, sodaß die gemessenen Werte die Rechenwerte gut bestätigen und jedenfalls erheblich besser sind, als diejenigen der bekannten Abzweigeinrichtungen. So weist z. B. ein Zweifach-Abzweiger mit jeweils 14 dB Auskoppeldämpfung nach der Erfindung, der mit der entsprechenden Einrichtung in Fig. 5 der DE-AS 24 25 722 direkt vergleichbar ist, folgende Werte auf :

Siehe Tabelle, Seite 4 f.

| | | VHF | UHF |
|---|---|---|---|
| Rückflußdämpfungen | $a_{rE}$ $a_{rA}$ | > 30 dB | |
| | $a_{rAB1}$ $a_{rAB2}$ | > 25 dB | > 20 dB |
| Stamm-Durchgangsdämpfung | $a_d$ | < 1 dB | < 2 dB |
| Koppeldämpfungen | $a_{AB1-A}$ $a_{AB2-A}$ | > 30 dB | |

Insgesamt ist durch die erfindungsgemäße Mehrfach-Abzweigeinrichtung also eine Schaltung geschaffen, welche gegenüber dem Stand der Technik mit äußerst geringem Aufwand über den gesamten angegebenen Frequenzbereich Höchstwerte für die Anpassung aller Anschlüsse, die Entkopplungen und die übertragene Leistung bietet und auch für relativ kleine Auskoppeldämpfungen geeignet ist.

In den Unteransprüchen sind vorteilhafte Ausgestaltungen bzw. Ausbildungen des Gegenstandes nach Anspruch 1 angegeben.

Durch eine Schaltungsmaßnahme nach Anspruch 2 ist auf einfache und kostengünstige Weise der Betriebsfrequenzbereich zu tieferen Frequenzen hin erweiterbar.

Die Kettenschaltung wird im Aufwand noch günstiger durch einen Aufbau gemäß Anspruch 3. Das Einsparen von Material (Kerne und Spulen) und Herstellkosten macht sich besonders günstig bei Einrichtungen mit einer hohen Zahl von Abzweigern bemerkbar. Außerdem sinkt die resultierende Induktivität weniger stark ab als wenn für jeden Spannungsübertrager eine eigene Primärspule vorgesehen ist, so daß z. B. bei einem Vierfach-Abzweiger noch etwa die halbe anstatt nur ca. einem Viertel der Induktivität der Einzelwicklung wirksam ist, was eine demgegenüber weitere Absenkung der unteren Grenzfrequenz zur Folge hat. Schließlich ist durch diese Ausbildung eine geringere Durchgangsdämpfung erreicht (z. B. um bis zu 1 dB bei einem Zweifach- und 2 dB bei einem Vierfach-Abzweiger mit jeweils 14 dB Auskoppeldämpfung). Theoretisch ist der Aufbau einer Abzweigeinrichtung mit beliebig vielen Abzweigen und nur einer einzigen Primärwicklung für alle Spannungsübertrager möglich. Praktisch stößt man jedoch bei der Zusammenfassung von etwa 8 Richtkopplern an fertigungstechnische Grenzen, die insbesondere bei höheren Frequenzen hauptsächlich durch die räumlichen Abmessungen und — sofern die Sekundärwicklungen nicht nur eine halbe, die Kernbohrung jeweils nur einmal durchsetzende, sondern eine ganze Windung oder mehr aufweist — durch das schwierige Wickeln des Übertragers bedingt sind.

Die Auskopplung von Teilfrequenzbereichen gemäß Anspruch 4 ist in bestimmten praktischen Fällen, bei denen es besonders auf hohe Entkopplung ankommt, z. B. als VHF/UHF-Weiche oder für Meßzwecke mit Vorteil anwendbar.

Eine Verwendung der erfindungsgemäßen Zweifachabzweiger nach Anspruch 5 als Antennensteckdosen ist insbesondere im Hinblick auf die damit ohne Filter erreichbaren hohen Entkopplungswerte besonders günstig (> 50 dB zwischen verschiedenen Dosen). Dabei sind grundsätzlich keine Selektions — mittel zum Auftrennen in RF- und FS-Frequenzbereiche nötig, weil diese bereits in den betreffenden empfängereingangsschaltungen enthalten sind. Derartige Antennensteckdosen zeichnen sich also auch durch einen äußerst geringen Schaltungsaufwand aus. Schließlich sind beide Abzweiganschlüsse wahlweise für RF oder FS benutzbar. Damit sind diese Antennensteckdosen insgesamt nicht nur solchen ohne Richt — koppler überlegen (die einen hohen Filteraufwand benötigen), sondern auch Richtkopplerdosen, wie sie beispielsweise aus der DE-OS 23 091 51 bekannt sind. Bei diesen ist zwar die Entkopplung für Normalfälle ausreichend, bei Übertragung von Fernsehen in den unteren Sonderkanälen und Rundfunk im oberen UKW-Bereich in Störungsfällen (z. B. bei Kurzschluß oder Leerlauf eines Empfängeranschlußkabels) jedoch nicht ohne zusätzlichen Filteraufwand ausreichend. Außerdem ist durch den Differentialübertrager ein Verlust von ca. 3 dB unvermeidbar, wodurch bei einer bestimmten Auskoppeldämpfung der Empfängeranschlüsse diejenige der Richtkoppler geringer sein muß, was wiederum eine Erhöhung der Durchgangsdämpfung bewirkt. Demgegenüber benötigt die erfindungsgemäße Schaltung bei trotz der Zusammenschaltung zweier Richtkoppler nur etwa gleich großer Durchgangsdämpfung einen erheblich geringeren Schaltungsaufwand (insbesondere bei einer Ausgestaltung nach Anspruch 3). Darin ist der Verlust eines geringen Teiles der Signalenergie des Fernsehbereiches im Rundfunkzweig und umgekehrt (z. B. etwa 0,2 dB bei einem 14 dB-Abzweiger) bereits enthalten. Dieser Verlust steigt allerdings bei Richtkopplern mit geringerer Auskoppeldämpfung an.

Für solche Anwendungsfälle ist es, insbesondere bei Verwendung einer größeren Anzahl von Antennensteckdosen, vorteilhaft, eine Ausführung gemäß Anspruch 6 zu verwenden, bei der an jedem Abzweiganschluß die maximal mögliche Signalenergie zur Verfügung steht, wobei die Auskoppeldämpfung bei phasenrichtiger Zusammenschaltung der beiden Richtkoppler um etwa 3 dB niedriger ist als beim Einzelrichtkoppler. Allerdings sind bei diesen selektiven Abzweigern nicht nur die Aufwendungen höher, sondern auch die Werte für die Rückflußdämpfungen an den Empfängeranschlüssen und die Koppeldämpfung zwischen diesen nicht mehr so günstig. Dieser Nachteil ist jedoch bei Antennensteckdosen in aller Regel von ebenso untergeordneter Bedeutung wie die Tatsache, daß jeder der beiden Anschlüsse einem Teilfrequenzbereich (RF oder FS) fest zugeordnet und nicht für beide verwendbar ist.

Zur weiteren Verbesserung der Durchgangsdämpfung, sowie der Rückflußdämpfung für alle Anschlüsse ist es zweckmäßig, die aus der DE-OS 27 03 258 an sich bekannten Maßnahmen gemäß Anspruch 7 anzuwenden.

Durch die in Anspruch 8 angegebenen Merkmale ist eine wesentliche fertigungstechnische Vereinfachung des Schaltungsaufbaus und damit eine beträchtliche Reduzierung der Herstellkosten erreicht. Dies gilt insbesondere für Vielfachabzweiger mit Spannungsübertragern, deren Sekundärwicklungen nur eine halbe, als durch die Kernbohrungen geführter gestreckter Draht ausgebildete Windung aufweisen.

In den Fig. 5-8 sind die Schaltbilder dreier Ausführungsbeispiele der erfindungsgemäßen Mehrfach-Abzweigeinrichtung, sowie das Wickelschema eines weiteren Ausführungsbeispiels dargestellt.

Fig. 5 zeigt einen Zweifach-Abzweiger aus zwei hintereinandergeschalteten Richtkopplern der Typen B und A mit einem Koppelkondensator C zur Erweiterung des Betriebsfrequenz bereiches zu tiefen Frequenzen hin. Diese Ausführung weist bereits alle zum Anspruch 1 beschriebenen Vorteile auf, da bei idealer Entkopplung eine exakte Kompensation durch die beiden gegenläufigen Impedanz-Transformationen und damit eine gute Anpassung und minimale Durchgangsdämpfung erreicht ist. Die Schaltung arbeitet praktisch ohne besondere Maßnahmen von 5-860 MHz mit diesen guten elektrischen Daten.

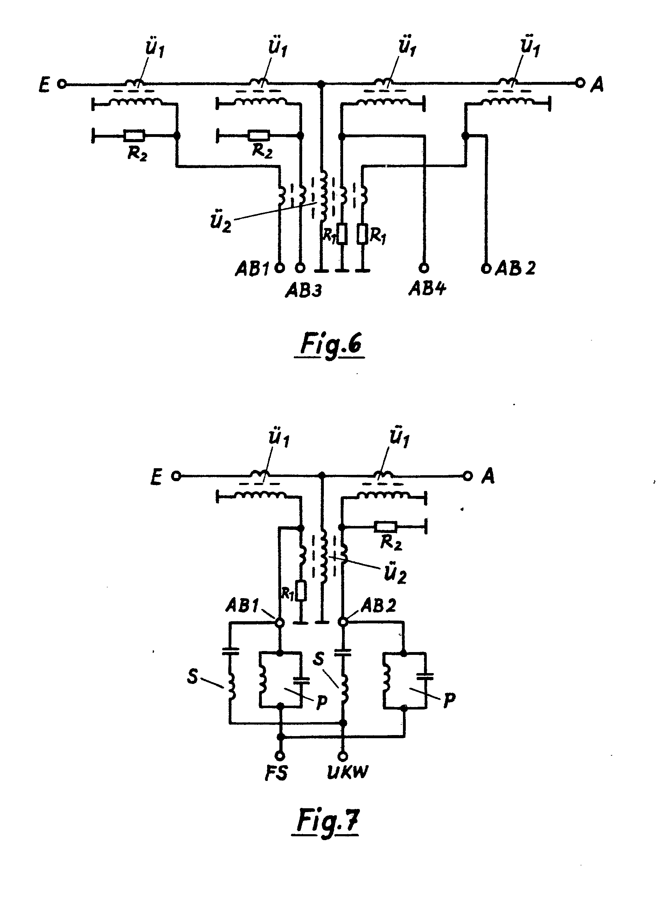

Bei der in Fig. 6 dargestellten Vierfach-Abzweigeinrichtung ist nur eine einzige Primärwicklung und ein einziger Kern für den Spannungsübertrager verwendet.

Diese Ausführung bringt gegenüber der mit je einer Primärwicklung für jeden Spannungsübertrager nicht nur eine wesentliche Einsparung von Material und Herstellkosten mit sich, sondern eine geringere Absenkung der resultierenden Induktivität der Primärspulen der Spannungsübertrager und damit eine kleinere Erhöhung der unteren Grenzfrequenz. Außerdem ist im Vergleich zu einem entsprechend Fig. 5 aufgebauten Vierfach-Abzweiger wegen der geringeren Kern- und Streuverluste eine wesentliche Verringerung der Durchgangsdämpfung (bis zu 2 dB bei Verwendung von 14 dB-Richtkopplern) erreichbar. Schließlich ist bei dieser Schaltung ein sternförmiger Aufbau möglich, der in vielen Fällen eine räumlich kleinere und bezüglich der Anschlüsse günstigere Anordnung ergibt.

In Fig. 7 ist eine Abzweigeinrichtung für Antennensteck dosen gezeigt, bei der der Doppelabzweiger nach Anspruch 3 durch die in Anspruch 7 angegebenen Selektionsmittel ergänzt ist. Damit ist eine Antennensteckdose geschaffen, die sich bei maximaler Energieübertragung auf die Empfängeranschlüsse und verhältnismäßig geringem Schaltungsaufwand durch eine geringe Durchgangsdämpfung auszeichnet. Die dadurch erreichte gute Kaskadierbarkeit ist gerade bei Antennensteckdosen besonders wichtig, weil dafür in der Praxis ein großer Anwendungsbereich besteht.

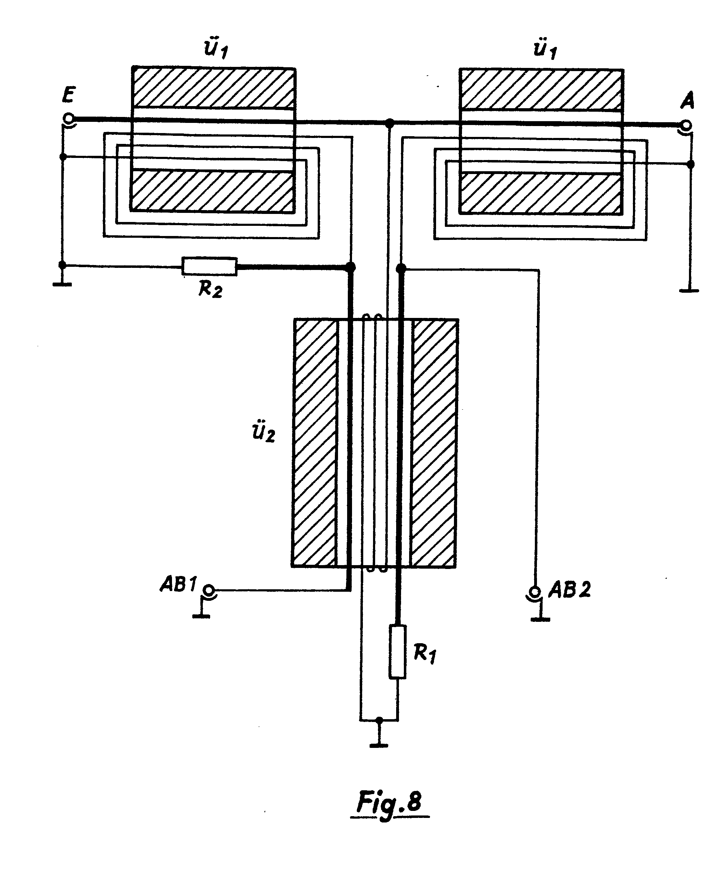

Aus dem in Fig. 8 gezeigten Wickelschema eines Zweifach-Abzweigers mit einer Auskoppeldämpfung von etwa 14 dB, aufgebaut aus je einem Richtkoppler nach Fig. 3 und Fig. 1 unter Berücksichtigung der in Anspruch 3 beschriebenen Vereinfachung, ist die dabei mögliche einfache und übersichtliche Ausführung erkennbar.

In Verbindung mit der Verwendung der Anschlußdrähte der Widerstände $R_1$ und $R_2$ als Sekundärwicklungen des Spannungsübertragers $Ü_2$ ist somit eine äußerst kostengünstige Herstellung ermöglicht.

## Ansprüche

1. Mehrfach-Abzweigeinrichtung für Hochfrequenzsignale im VHF-UHF-Bereich (5-860 MHz), insbesondere zur Verwendung in Gemeinschaftsantennenanlagen, bestehend aus wenigstens zwei in Kette geschalteten Richtkopplern zum breitbandig richtungsabhängigen Auskoppeln eines Teils der über eine Stammleitung geführten Signalenergie auf jeweils einen Abzweiganschluß (AB), die derart unterschiedlich ausgebildet sind, daß sie in alternierender Reihenfolge zusammengeschaltet — nacheinander die jeweilige Eingangsimpedanz herab- bzw. herauftransformieren, dadurch gekennzeichnet, daß jeder Richtkoppler zwei voneinander getrennte Übertrager ($Ü_1$, $Ü_2$) aufweist, wobei die Primärwicklung des ersten (Strom-) Übertragers ($Ü_1$) zwischen dem Eingang (E) und dem Ausgang (A), diejenige des zweiten (Spannungs-) Übertragers ($Ü_2$) zwischen Eingang (E) oder Ausgang (A) und Masse liegt und die Sekundärwicklung des Strom-Übertragers ($Ü_1$) einerseits mit Masse und zum anderen mit der Sekundärwicklung des Spannungsübertragers ($Ü_2$) verbunden ist, und daß bei den herabtransformierenden Richtkopplern (Typ A) der Abzweigan schluß (AB) zwischen den beiden Sekundärwicklungen und das andere Ende der Sekundärwicklung des Spannungsübertragers ($Ü_2$) über einen ohm'schen Widerstand ($R_1$) an Masse liegt, während bei den aufwärtstransformierenden Richtkopplern (Typ B) der Widerstand ($R_2$) zwischen dem Verbindungspunkt der Sekundärwicklungen und Masse eingeschaltet ist und das andere Ende der Sekundärwicklung des Spannungsübertragers ($\ddot{U}_2$) den Abzweiganschluß (AB) bildet.

2. Mehrfach-Abzweigeinrichtung nach Anspruch 1, dadurch gekennzeichnet, daß je zwei aufeinanderfolgende Richtkoppler durch einen in die Stammleitungen eingeschalteten Kondensator (C) sur Tiefpaßkompensation verbunden sind.

3. Mehrfach-Abzweigeinrichtung nach Anspruch 1 oder 2, dadurch gekennzeichnet, daß für die Spannungsübertrager ($\ddot{U}_2$) wenigstens zweier Richtkoppler nur eine einzige Primärwicklung vorgesehen ist.

4. Mehrfach-Abzweigeinrichtung nach einem der Ansprüche 1 bis 3, dadurch gekennzeichnet, daß jeweils zwei benachbarte Richtkoppler zu Zweifach-Abzweigern zusammengefaßt und den beiden Abzweiganschlüssen (AB1, AB2) Selektionsmittel (S, P) nachgeschaltet sind, über die jeweils ein Teil des Betriebs frequenzbereiches auskoppelbar ist.

5. Mehrfach-Abzweigeinrichtung nach einem der Ansprüche 1 bis 3, dadurch gekennzeichnet, daß jeweils zu Zweifach-Abzweigern zusammengefaßte benachbarte Richtkoppler als Antennensteckdosen verwendet sind.

6. Mehrfach-Abzweigeinrichtung nach Anspruch 4, dadurch gekennzeichnet, daß die Zweifachabzweiger als Antennensteckdosen verwendet sind und zur Selektion die beiden Abzweiganschlüsse (AB1, AB2) über je einen als UKW-Sperre dienenden Parallelresonanzkreis (P) mit dem FS-Empfängeranschluß (FS), sowie über je einen auf UKW abgestimmten Serien resonanzkreis (S) mit dem UKW-Empfängeranschluß (UKW) verbunden sind.

7. Mehrfach-Abzweigeinrichtung nach einem der Ansprüche 1 bis 6, dadurch gekennzeichnet, daß bei jedem Richtkoppler für die Übertrager Rohrkerne verwendet sind, wobei das Volumen und/oder die relative Permeabilität des Stromübertragerkernes kleiner ist als diejenige des Spannungsübertragerkerns, daß die Windungen der Sekundärwicklung des Stromübertragers ($\ddot{U}1$) gleichmäßig am Umfang des Kerns verteilt sind und die der Sekundärwicklung des Spannungsübertragers ($\ddot{U}_2$) nahe beieinander liegen, und daß innerhalb der Kernbohrung des Stromübertragers ($\ddot{U}_1$) die Primärwicklung einen konstanten Abstand von der Sekundärwickung aufweist.

8. Mehrfach-Abzweigeinrichtung nach einem der Ansprüche 1 bis 7, dadurch gekennzeichnet, daß als Sekundärwicklung des Spannungsübertragers ($\ddot{U}_2$) der eine Anschlußdraht des Widerstandes ($R_1$, $R_2$) verwendet ist.

## Claims

1. High-frequency multiple-distribution circuit arrangement for signals in the VHF-UHF range (5-860 MHz), particularly for use in community antenna systems, comprising at least two cascade-connected directional couplers for the broad-band direction-dependent coupling of a part of the signal energy conducted via a trunk line onto a distribution connection (AB), said directional couplers being of different design such that — coupled in alternating sequence — they consecutively transform the respective input impedance up and down, wherein each directional coupler exhibits two separate transformers ($\ddot{U}_1$, $\ddot{U}_2$) whereby the primary winding of the first (current) transformer ($\ddot{U}_1$) is between the input (E) and the output (A), that of the second (voltage) transformer ($\ddot{U}_2$) being between input (E) or output (A) and ground, and the secondary winding of the current transformer ($\ddot{U}_1$) is connected firstly to ground and secondly to the secondary winding of the voltage transformer ($\ddot{U}_2$) whereby in the case of the step-down directional couplers (type A) the distribution connection (AB) is between the two secondary windings and the other end of the secondary winding of the voltage transformer ($\ddot{U}_2$) is connected via an ohmic resistor ($R_1$) to ground while in the case of the step-up directional couplers (type B) the resistor ($R_2$) is connected between the connecting point of the secondary windings and ground and the other end of the secondary winding of the voltage transformer ($\ddot{U}_2$) forms the distribution connection (AB).

2. High-frequency multiple-distribution circuit arrangement as defined in claim 1, wherein for the purpose of low-pass compensation every two consecutive directional couplers are connected by a capacitor (C) which is connected into the trunk lines.

3. High-frequency multiple-distribution circuit arrangement as defined in claim 1 or 2, wherein only one single primary winding is provided for the voltage transformers ($\ddot{U}_2$) of at least two directional couplers.

4. High-frequency multiple-distribution circuit arrangement as defined in any one of claims 1 to 3, wherein each two neighbouring directional couplers are combined to form double distributors whereby connected after the two distribution connections (AB1, AB2) are selection means (S, P) through each of which a part of the operating frequency range can be coupled.

5. High-frequency multiple-distribution circuit arrangement as defined in any one of claims 1 to 3, wherein neighbouring directional couplers which have been combined to form double distributors are used as antenna sockets.

6. High-frequency multiple-distribution circuit arrangement as defined in claim 4, wherein the double distributors are used as antenna sockets and, for selection, the two distribution connections (AB1, AB2) are each connected via a parallel resonant circuit (P) serving as a VHF block to the TV receiver connection (FS), and via a VHF-tuned series resonant circuit (S) to the VHF receiver connection (UKW).

7. High-frequency multiple-distribution circuit arrangement as defined in any one of claims 1 to 6, wherein for each directional coupler tubular cores are used for the transformers whereby the volume and/or the relative permeability of the current transformer core is smaller than that of the voltage transformer core whereby the turns of the secondary winding of the current transformer ($\ddot{U}_1$) are evenly distributed over the circumference of the core and those of the secondary winding of the voltage transformer ($\ddot{U}_2$) are closely juxtaposed whereby inside the core hole of the current transformer ($\ddot{U}_1$) the primary winding is at a constant distance from the secondary winding.

8. High-frequency multiple-distribution circuit arrangement as defined in any one of claims 1 to 7, wherein one of the connecting wires of the resistor ($R_1$, $R_2$) is used as the secondary winding of the voltage transformer ($\ddot{U}_2$).

**Revendications**

1. Dispositif répartiteur multiple pour signaux à hautes fréquences dans la bande VHF-UHF (5-860 MHz), en particulier pour une utilisation sur des installations d'antennes collectives, comprenant au moins deux coupleurs directifs montés en cascade destinés au découplage sur respectivement une prise de dérivation (AB) d'une partie de l'énergie d'un signal transitant par une ligne dorsale, les coupleurs directifs ayant une conception distincte telle que, lorsqu'ils sont interconnectés alternativement, ils élèvent et abaissent successivement l'impédance d'entrée respective, caractérisé en ce que chaque coupleur directif présente deux transformateurs ($\ddot{U}_1$, $\ddot{U}_2$) distincts, l'enroulement primaire du premier transformateur (de courant) ($\ddot{U}_1$) étant monté entre l'entrée (E) et la sortie (A), celui du deuxième transformateur (de tension) ($\ddot{U}_2$) entre l'entrée (E) ou la sortie (A) et la masse et l'enroulement secondaire du transformateur de courant ($\ddot{U}_1$) étant relié d'une part à la masse et d'autre part à l'enroulement secondaire du transformateur de tension ($\ddot{U}_2$), et en ce que sur les coupleurs directifs abaisseurs (type A) la prise de dérivation (AB) est montée entre les deux enroulements secondaires et que l'autre extrémité de l'enroulement secondaire du transformateur de tension ($\ddot{U}_2$) est relié à la masse par une résistance ohmique ($R_1$), alors que sur les coupleurs directifs élévateurs (B) la résistance ($R_2$) est montée entre le point de raccordement des enroulements secondaires et la masse et que l'autre extrémité de l'enroulement secondaire du transformateur de tension ($\ddot{U}_2$) constitue la prise de dérivation (AB).

2. Dispositif répartiteur multiple suivant la revendication 1, caractérisé en ce que respectivement deux coupleurs directifs successifs sont reliés par un condensateur (C) monté dans la ligne dorsale pour assurer une compensation passe-bas.

3. Dispositif répartiteur multiple suivant l'une des revendications 1 ou 2, caractérisé en ce qu'un seul enroulement primaire a été prévu pour les transformateurs de tension ($\ddot{U}_2$) d'au moins deux coupleurs directifs.

4. Dispositif répartiteur multiple suivant l'une quelconque des revendications 1 à 3, caractérisé en ce que respectivement deux coupleurs directifs contigus sont regroupés en une double dérivation et que les deux prises de dérivation (AB1, AB2) sont équipées en aval d'un dispositif de sélection (S, P) permettant de découpler respectivement une partie de la bande de fréquence de service.

5. Dispositif répartiteur multiple suivant l'une quelconque des revendications 1 à 3, caractérisé en ce que des coupleurs contigus regroupés en doubles dérivations sont utilisés comme prises d'antenne.

6. Dispositif répartiteur multiple suivant la revendication 4, caractérisé en ce que les doubles dérivations sont utilisées comme prises d'antenne et que pour la sélection les deux prises de dérivation (AB1, AB2) sont reliées respectivement à la prise de récepteur de télévision (FS) par l'intermédiaire d'un circuit résonnant parallèle (P) servant de réjecteur FM de même que respectivement à la prise de récepteur FM (UKW) par l'intermédiaire d'un circuit résonnant série (S) syntonisé à la FM.

7. Dispositif répartiteur multiple suivant l'une quelconque des revendications 1 à 6, caractérisé en ce que des noyaux tubulaires sont utilisés pour les transformateurs de chaque coupleur directif, le volume et/ou la perméabilité relative du noyau du transformateur de courant étant inférieurs à ceux du noyau du transformateur de tension, en ce que les spires de l'enroulement secondaire du transformateur de courant ($\ddot{U}_1$) sont réparties régulièrement sur la périphérie du noyau et que celles de l'enroulement secondaire du transformateur de tension ($\ddot{U}_2$) sont rapprochées les unes des autres et en ce que à l'intérieur de l'alésage du noyau du transformateur de courant ($\ddot{U}_1$) l'enroulement primaire présente un espacement constant par rapport à l'enroulement secondaire.

8. Dispositif répartiteur multiple suivant l'une quelconque des revendications 1 à 7, caractérisé en ce que l'un des fils de connexion de la résistance ($R_1$, $R_2$) est utilisé comme enroulement secondaire du transformateur de tension ($\ddot{U}_2$). ·

Fig.1

Fig.2

Fig.3

Fig.4

Fig.5

_Fig.6_

_Fig.7_

**Fig.8**